# EUROPÄISCHE PATENTSCHRIFT

(11) **EP 1 565 948 B1**
(45) Veröffentlichungstag und Bekanntmachung des Hinweises auf die Patenterteilung: **16.03.2016**
(21) Anmeldenummer: 03767463.7
(22) Anmeldetag: 27.11.2003
(51) Int. Cl.: H01L 33/48, H01L 33/62, H01L 31/0203

(54) **OPTOELEKTRONISCHES BAUELEMENT**
OPTOELECTRONIC COMPONENT
COMPOSANT OPTOELECTRONIQUE

(30) Priorität: 29.11.2002 DE 10255932
(43) Veröffentlichungstag der Anmeldung: 24.08.2005
(73) Patentinhaber: OSRAM Opto Semiconductors GmbH, 93055 Regensburg (DE)
(72) Erfinder: ARNDT, Karlheinz, 93077 Bad Abbach (DE); BOGNER, Georg, 93138 Lappersdorf (DE); WAITL, Günter, 93049 Regensburg (DE); WINTER, Matthias, 93059 Regensburg (DE)
(74) Vertreter: Epping - Hermann - Fischer
(86) Internationale Anmeldenummer: PCT/DE2003/003923
(87) Internationale Veröffentlichungsnummer: WO 2004/051757

(56) Entgegenhaltungen:
- JP-A- 59 010 288
- US-A1- 2002 070 387
- US-A1- 2002 113 244
- US-A1- 2003 141 813
- US-B1- 6 392 294
- PATENT ABSTRACTS OF JAPAN Bd. 0171, Nr. 37 (E-1335), 22. März 1993 (1993-03-22) & JP 4 307975 A (SHARP CORP), 30. Oktober 1992 (1992-10-30)
- PATENT ABSTRACTS OF JAPAN Bd. 1998, Nr. 10, 31. August 1998 (1998-08-31) & JP 10 144965 A (HAMAMATSU PHOTONICS KK), 29. Mai 1998 (1998-05-29)
- PATENT ABSTRACTS OF JAPAN Bd. 2000, Nr. 23, 10. Februar 2001 (2001-02-10) & JP 2001 177151 A (SHARP CORP), 29. Juni 2001 (2001-06-29)
- PATENT ABSTRACTS OF JAPAN Bd. 0040, Nr. 44 (E-005), 5. April 1980 (1980-04-05) & JP 55 016415 A (HITACHI LTD), 5. Februar 1980 (1980-02-05)
- PATENT ABSTRACTS OF JAPAN Bd. 2000, Nr. 11, 3. Januar 2001 (2001-01-03) & JP 2000 216413 A (APIC YAMADA CORP), 4. August 2000 (2000-08-04)
- PATENT ABSTRACTS OF JAPAN Bd. 1999, Nr. 11, 30. September 1999 (1999-09-30) & JP 11 150295 A (SONY CORP), 2. Juni 1999 (1999-06-02)

## Beschreibung

Die Erfindung betrifft ein optoelektronisches Bauelement mit einem optoelektronischen Chip und einem Chipträger sowie mit einem Gehäuse.

Bauelemente der eingangs genannten Art sind beispielsweise bekannt aus der Druckschrift WO 99/07023. Bei diesen Bauelementen ist ein optoelektronischer Chip auf einem Chipträger befestigt. Der Chip und Teile des Chipträgers sind von einem Gehäuse umgeben und in dieses Gehäuse eingebettet. Das Gehäuse kann beispielsweise mittels Umspritzen gefertigt werden. Der Chipträger weist einen Bereich auf, auf dem der optoelektronische Chip befestigt ist. Darüber hinaus weist der Chipträger Anschlüsse auf, die von dem den Chip tragenden Bereich nach außen aus dem Gehäuse herausgeführt sind. Dort bilden die Anschlüsse im allgemeinen Lötflächen, mit deren Hilfe das Bauelement auf einer Platine festgelötet werden kann.

Bauelemente der genannten Art werden beispielsweise als Leuchtdioden zunehmend als bevorzugte Leuchtquellen in der Industrie, in der Automobiltechnik, in der Telekommunikation und ferner auch in anderen Bereichen eingesetzt. Damit steigen auch die Anforderungen an die mechanische Belastbarkeit und die Zuverlässigkeit der Bauelemente stark an. Insbesondere sind die mechanischen Anforderungen bei der thermomechanischen Belastbarkeit hoch.

Die Zuverlässigkeit eines solchen Bauelements kann mit einer Kennzahl erfaßt werden, die die Einheit Parts-per-Million (ppm) hat. Dabei wird ermittelt, wie viele Bauteile von einer Million Stück eine Ausfallerscheinung zeigen. Es werden inzwischen Ausfallraten nahe bei 0 ppm gefordert.

Die bekannten Bauteile der eingangs genannten Art haben den Nachteil, daß sie hinsichtlich der Zuverlässigkeit die gewünschte Ausfallrate nicht erreichen können. Eine charakteristische Schwäche besteht darin, daß die Verbindung zwischen dem optoelektronischen Chip und dem Chipträger zu häufig beschädigt wird oder ganz aufreißt. Die Ursache hierfür kann darin liegen, daß bei einer Temperaturbelastung des Bauelements, wie sie beispielsweise beim Festlöten der Anschlüsse auf einer Platine auftreten, die unterschiedlichen thermomechanischen Eigenschaften der verwendeten Materialien belastend zu Tage treten. Beispielsweise ist es üblich, bei der Fertigung der Bauelemente Materialien mit stark unterschiedlichen thermischen Ausdehnungskoeffizienten zu verwenden. Darüber hinaus unterscheiden sich die Materialien, beispielsweise des Chipträgers und des Gehäuses hinsichtlich ihres Elastizitätsmoduls. Bei einer thermischen Belastung entstehen aufgrund dieser Materialunterschiede starke mechanische Kräfte, die die einzelnen Materialkomponenten verformen oder auch gegeneinander verschieben bzw. scheren können.

Dies führt dazu, daß die Gefahr eines Ausfalls der Bauelemente nach dem Löten erhöht wird, wobei als Ursache häufig eine Lösung der elektrischen oder der mechanischen Verbindung zwischen dem Chipträger und dem Chip ausgemacht werden kann. Dabei können schon geringe Erwärmungen des Bauelements zu einem geöffneten elektrischen Kontakt zwischen dem Chip und dem Chipträger führen.

Die Druckschriften JP 2001-177151 A, JP H04-307975 A sowie JP S59-010288 A betreffen jeweils LED-Bauteile, bei der ein LED-Chip auf einem in Draufsicht gesehen punktsymmetrischen Chipträger angebracht ist, wobei der LED-Chip in einem strahlungsdurchlässigen Vergusskörper, der keine Ausnehmung aufweist, untergebracht ist.

Aus der Druckschrift US 2002/0070387 A1 ist ein LED-Bauteil bekannt, bei dem sich ein LED-Chip in einer Ausnehmung eines lichtundurchlässigen Grundgehäuses auf einem Leiterrahmen befindet.

Es ist daher Aufgabe der vorliegenden Erfindung, ein Bauelement der eingangs genannten Art anzugeben, dessen Zuverlässigkeit erhöht ist.

Diese Aufgabe wird gelöst durch ein optoelektronisches Bauelement nach Patentanspruch 1 und eine Anordnung nach Patentanspruch 10. Vorteilhafte Ausgestaltungen des Bauelements sind den Patentansprüchen 2-9 zu entnehmen.

Die Erfindung basiert auf dem Grundgedanken, daß eine möglichst symmetrische Gestaltung des Bauelementes angestrebt wird, um die bei Temperaturbelastung auftretenden Kräfte, insbesondere die Kräfte, die zwischen dem optoelektronischen Chip und dem Chipträger wirken, zu minimieren. Insbesondere wird dies versucht durch eine punktsymmetrische Gestaltung des Bauelements. Dabei wird der Effekt genutzt, daß es bei einer punktsymmetrischen Gestaltung eines Körpers zu jedem Punkt des Körpers, auf den eine thermomechanische Kraft wirkt, einen dazu spiegelsymmetrischen Punkt desselben Körpers gibt, auf den eine betragsmäßig gleiche, jedoch in die entgegengesetzte Richtung wirkende Kraft wirkt. Dementsprechend existiert in dem Körper ein Punkt, an dem sich alle wirkenden Kräfte im wesentlich gegenseitig kompensieren. Dies ist der Punkt, zu dem der Körper punktsymmetrisch ist. Vorzugsweise ist dann in diesem Symmetriepunkt das Bauelement anzuordnen. Die vorstehenden Betrachtungen gelten insbesondere für den Körper, der das Bauelement umgibt.

Hinsichtlich des Chipträgers sind ähnliche Überlegungen angestellt worden. Jedoch ist hier aufgrund der bahnförmig verlaufenden Anschlüsse zunächst im wesentlichen auf die Längsmittelachsen der Anschlüsse des Chipträgers zu achten. Die Kräfte, die zwischen dem Chipträger und dem umgebenden Gehäuse wirken, wirken nämlich hauptsächlich entlang der Längsmittelachsen der Anschlüsse. Hierzu sei angemerkt, daß es beispielsweise vorkommen kann, daß beim Löten der Anschlüsse diese einer hohen Temperatur ausgesetzt sind, welche auch auf das Gehäuse übertragen wird. Nach dem Löten kühlen die Anschlüsse des Chipträgers wesentlich schneller ab als das Gehäuse, was unter anderem auf die bessere Wärmeleitfähigkeit der Anschlüsse und auch auf deren thermischen Kontakt zu Leiterbahnen auf einer Leiterplatte zurückgeführt werden kann. Es entsteht somit ein Temperaturunterschied, der zu einer Scherbeanspruchung zwischen den Anschlüssen und dem umgebenden Körper führt. Eine solche Scherbeanspruchung kann repräsentiert werden durch eine Kraft, die entlang der Längsmittelachse des jeweiligen Anschlusses wirkt. Es ist also gemäß der Erfindung auch darauf zu achten, daß neben dem Gehäuse auch die Längsmittelachsen der Anschlüsse des Chipträgers die notwendige Symmetrie aufweisen, um zu einer Kompensation der Kräfte zu gelangen.

Es wird ein optoelektronisches Bauelement angegeben, das einen optoelektronischen Chip enthält. Es ist ferner ein Chipträger vorgesehen mit einem zentralen Bereich, auf dem der Chip befestigt ist. Darüber hinaus weist der Chipträger Anschlüsse auf, die vom zentralen Bereich des Chipträgers ausgehend nach außen verlaufen. Der optoelektronische Chip und Teile des Chipträgers sind von einem Körper umhüllt. Die Anordnung des Chips, die Formgebung des Körpers und die Formgebung des Chipträgers sind nun so gewählt, daß die Projektion des Körpers sowie der Längsmittelachsen der Anschlüsse auf eine Kontaktebene zwischen Chip und Chipträger jeweils punktsymmetrisch zur Projektion des Mittelpunktes des Chips sind.

Bevorzugt verlaufen hierbei die Anschlüsse vom Chipträger aus im wesentlichen in einer Ebene nach außen.

Die Kontaktebene zwischen Chip und Chipträger ist durch die Montageebene gegeben sein, in der der Chip auf den Chipträger montiert wird.

Es wird darauf hingewiesen, daß zur Vereinfachung in diesem Text die Formulierung "punktsymmetrisch zum Mittelpunkt" synonym verwendet wird zur Formulierung "punktsymmetrisch zur Projektion des Mittelpunktes".

Durch die symmetrische Gestaltung des Bauelements ist erreicht, daß auftretende thermomechanische Kräfte sich gegenseitig kompensieren und dadurch die Gefahr eines Ausfalls des Bauelementes vermindert werden kann.

In einer Ausführungsform des Bauelements kann der Körper aus einem strahlungsdurchlässigen Material bestehen. Dies hat den Vorteil, daß das in dem Chip erzeugte Licht unmittelbar durch den Körper ausgekoppelt werden kann.

Erfindungsgemäß umfaßt der Körper ein Gehäuse, das mit einer Vertiefung versehen ist. In der Vertiefung ist eine strahlungsdurchlässige Umhüllung angeordnet. Der Chip ist in diese Umhüllung eingebettet. Die Projektion der Umhüllung auf die Ebene ist punktsymmetrisch zum Mittelpunkt des Chips.

Dies hat den Vorteil, daß das strahlungsdurchlässige Material nur dort verwendet wird, wo es auch gebraucht wird, nämlich in der unmittelbaren Umgebung des Chips. Der Rest des Körpers kann als Gehäuse ausgebildet sein, welches nicht notwendigerweise strahlungsdurchlässig zu sein braucht und für das folglich eine Vielzahl von geeigneten Materialien zur Verfügung steht, welche beispielsweise hinsichtlich Gewicht, mechanischer Festigkeit, Verarbeitbarkeit, thermischer Ausdehnung usw. ausgewählt werden kann.

Für den Fall, daß der Körper aus zwei verschiedenen Materialien besteht, ist besonders vorteilhaft sowohl das Gehäuse als auch die Umhüllung jeweils punktsymmetrisch zum Mittelpunkt geformt. Der Chip ist im Symmetriepunkt von Umhüllung und Gehäuse angeordnet. Dadurch kann erreicht werden, daß bei einer thermisch verursachten Verformung der Umhüllung in dem Gehäuse eine mechanische Belastung des Chips stark reduziert werden kann, da sich die Kräfte, die aufgrund der Verformung der Umhüllung auf den Chip wirken, aufgrund der Punktsymmetrie der Umhüllung bzw. aufgrund der Punktsymmetrie der Projektion der Umhüllung auf die Kontaktebene weitgehend kompensieren können.

Mit der Gestaltung des Körpers aus zwei Bestandteilen entsteht am Boden der Vertiefung eine Kontaktfläche zwischen der Umhüllung und dem Gehäuse. Je nach Bauart des Bauelements kann diese Kontaktfläche relativ groß sein, nämlich dann, wenn ein Großteil der Oberfläche des Chipträgers Kontakt zur Umhüllung hat. In diesem Fall entstehen Kontaktflächen zwischen Umhüllung und Gehäuse überall dort, wo der Boden der Vertiefung nicht von dem Chipträger bedeckt ist.

In einer nicht erfindungsgemäßen Abwandlung, wo die Technik des sog. "Overmold" angewendet wird, ist der Chipträger zu großen Teilen ganz in das Gehäuse eingebettet und der Kontakt zwischen der Umhüllung und dem Boden der Vertiefung findet fast über die gesamte Fläche des Bodens der Vertiefung statt.

In beiden Fällen ist die Projektion der Kontaktflächen zwischen der Umhüllung und dem Boden der Vertiefung auf die Kontaktebene wieder punktsymmetrisch zum Mittelpunkt des Chips ist. Dadurch kann erreicht werden, daß die zwischen dem Boden der Vertiefung und der Umhüllung wirkenden Scherkräfte sich gegenseitig möglichst gut kompensieren.

Es wird der Chipträger so gestaltet, daß nicht nur die Längsmittelachsen der Anschlüsse sondern der gesamte Chipträger so gestaltet ist, daß dessen Projektion auf die Ebene punktsymmetrisch zum Mittelpunkt des Chips ist.

Diese Ausführungsform hat den Vorteil, daß eine noch bessere Kompensation der wirkenden Kräfte erzielt werden kann.

Es sind weitere, vom Chipträger getrennte Anschlüsse vorgesehen, die zur Kontaktierung des Chips von der dem Chipträger gegenüberliegenden Seite her dienen. Auch diese Anschlüsse sind so gestaltet, daß ihre Längsmittelachsen und die Anschlüsse selbst in der Projektion auf die Kontaktebene betrachtet punktsymmetrisch sind zum Mittelpunkt des Chips.

In einer anderen Ausführungsform des Bauelements sind Mittel zur Verankerung des Chipträgers in dem Körper vorgesehen. Solche Mittel zur Verankerung können beispielsweise aus dem Chipträger geformte Widerhaken, in den Chipträger geformte Löcher oder auch beispielsweise in den Chipträger geformte Tiefenprägungen sein. Die Löcher und die Widerhaken sorgen für eine gute Durchdringung des Chipträgers mit dem Körper, wie sie beispielsweise beim Umspritzen des Chipträgers mit dem Körper entstehen kann. Diese Mittel zur Verankerung des Chipträgers können unsymmetrisch im Sinne der oben stehenden Betrachtungen angeordnet sein. D.h., daß die Mittel zur Verankerung des Chipträgers bezüglich ihrer Positionen keine Punktsymmetrie zum Mittelpunkt des Chips aufweisen müssen.

Jedoch ist es gemäß einer anderen Ausführungsform vorteilhaft, auch diese Mittel zur Verankerung des Chipträgers punktsymmetrisch zum Mittelpunkt des Chips im Sinne der oben genannten Ausführungen anzuordnen.

Gemäß einer anderen Ausführungsform des Bauelements sind die Mittel zur Verankerung des Chipträgers zwar nicht symmetrisch, jedoch gleichmäßig über den Chipträger verteilt, um zu verhindern, daß eine Hälfte des Chipträgers gut in dem Körper verankert ist, während die andere Hälfte, beispielsweise die gegenüberliegende Hälfte des Chipträgers glatt in dem Körper läuft. Dies würde allerdings die Gefahr erhöhen, daß unsymmetrische Scherkräfte zwischen dem Körper und dem Chipträger auftreten.

In einer anderen Ausführungsform des Bauelements ist es vorgesehen, daß jeder Anschluß auf der Rückseite des Körpers eine Lötfläche aufweist. Dies hat zum einen den Vorteil, daß das Bauelement mittels Oberflächenmontage auf einer Platine montiert werden kann. Zum anderen hat dies den Vorteil, daß die Symmetrie des Chipträgers gut ausgenutzt werden kann, da eine optimale Kompensation der wirkenden thermomechanischen Kräfte gerade dann stattfindet, wenn das Aufheizen des Chipträgers bei der Montage von allen Anschlüssen her hinreichend gleichzeitig erfolgt.

Es wird darüber hinaus noch eine Anordnung mit dem Bauelement angegeben, bei der die Lötflächen des Chipträgers mit den leitenden Flächen einer Leiterplatte verlötet sind.

Im folgenden wird die Erfindung anhand eines Ausführungsbeispiels sowie anhand von Abwandlungen und dazugehörigen Figuren näher erläutert:
- Figur 1: zeigt eine nicht erfindungsgemäße Abwandlung eines Bauelements in einem schematischen Querschnitt.
- Figur 2: zeigt eine schematische Darstellung einer Projektion auf die Ebene für ein Gehäuse, einen Chip und eine Umhüllung eines Ausführungsbeispiels des Bauelements.
- Figur 3: zeigt für eine nicht erfindungsgemäße Abwandlung des Bauelements eine schematische Darstellung einer Projektion des Chipträgers auf die Ebene.
- Figur 4: zeigt eine schematische Darstellung einer Projektion eines Chipträgers auf die Ebene für ein Ausführungsbeispiel.
- Figur 5: zeigt eine weitere schematische Darstellung einer Projektion eines nicht erfindungsgemäßen Chipträgers auf die Ebene.

Hinsichtlich der Figuren ist zu beachten, daß gleiche Bezugszeichen Elemente bezeichnen, die einander gleichen, oder die wenigstens gleiche oder ähnliche Funktionen erfüllen.

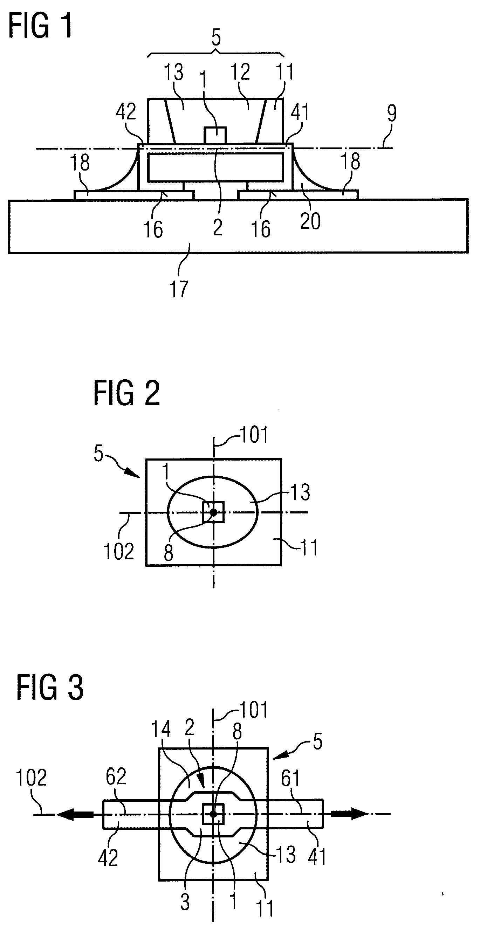

Figur 1 zeigt eine nicht erfindungsgemäße Abwanldung eines Bauelements mit einem optoelektronischen Chip 1, der auf einem Chipträger 2 befestigt ist. Der optoelektronische Chip 1 kann beispielsweise eine Leuchtdiode oder aber auch eine Laserdiode sein. Der optoelektronische Chip 1 kann vertikal oder auch lateral abstrahlen. Im zweiten Fall ist das Gehäuse 11 so gebildet, daß die Innenseiten der Vertiefung 12 einen Reflektor für das vom Chip 1 abgestrahlte Licht bilden.

Der Chipträger 2 kann beispielsweise aus einem Leiterrahmen (Leadframe) gefertigt sein. Dies hat den Vorteil, daß eine große Stückzahl von Bauelementen einfach und billig hergestellt werden kann. Der Chipträger 2 besteht in diesem Fall aus einem sehr dünnen leitfähigen Blech, aus dem eine bestimmte Form herausgestanzt worden ist. Beispielsweise kommt es in Betracht, eine Eisen-Nickel-Legierung als Material für den Chipträger 2 zu verwenden.

Der Chip 1 und der mittlere Teil des Chipträgers 2 sind umhüllt von einem Körper 5, der zusammengesetzt ist aus einem Gehäuse 11 und einer strahlungsdurchlässigen Umhüllung 13. Die strahlungsdurchlässige Umhüllung 13 besteht aus einem Material, das für die von dem Chip 1 emittierte Strahlung durchlässig ist. Es kommt beispielsweise in Betracht, für die Umhüllung 13 ein Harz zu verwenden.

Das Gehäuse 11 dient vorzugsweise der mechanischen Stabilisierung des Bauelements. Es kann beispielsweise aus einem Thermoplasten bestehen.

Hinsichtlich der Fertigung des Bauelements nach Figur 1 kann es vorgesehen sein, entsprechend der sog. "Premold"-Technik in einem ersten Schritt den Chipträger 2 mit dem Gehäuse 11 zu umspritzen. Zweiter Schritt ist, den Chip 1 und einen Draht in eine Öffnung (Kavität) des Gehäuses 11 zu montieren. In einem dritten Schritt wird dann die Umhüllung 13 in einer Vertiefung 12 des Gehäuses eingefüllt.

Das in Figur 1 konkret gezeigte Bauelement sieht von der Verwendung der sog. "Overmold"-Technik ab. Dies bedeutet, daß die Oberseite des Chipträgers 2 im Bereich der Vertiefung 12 nicht mit Material des Gehäuses 11 bedeckt ist. Dies hat zur Folge, daß ein unmittelbarer Kontakt zwischen der Umhüllung 13 und dem Boden des Gehäuses 11 nur an den von Chipträger 2 freien Stellen des Gehäusebodens gegeben ist. Gemäß einer anderen möglichen Ausführungsform würde man die "Overmold"-Technik anwenden, wo auch die Oberseite des Chipträgers 2 über große Flächen von Material des Gehäuses 11 bedeckt wäre. In diesem Fall ergäbe sich eine größere Kontaktfläche zwischen der Umhüllung 13 und dem Boden der Vertiefung 12 (vgl. Bezugszeichen Nr. 14 in den Figuren 3, 4 und 5).

Die gezeigten Bauelemente sind alle als ohne die "Overmold"-Technik hergestellte Bauelemente dargestellt.

Auf der Rückseite des Gehäuses 11 bilden Anschlüsse 41, 42 des Chipträgers 2 Lötflächen 16, die mit leitenden Flächen 18 einer Leiterplatte 17 verlötet sind.

Es ist noch darauf hinzuweisen, daß die Kontakt- beziehungsweise die Montagefläche zwischen dem Chip 1 und dem Chipträger 2 sowie die Teile der Anschlüsse 41, 42, die innerhalb des Körpers 5 liegen, im wesentlichen in einer einzigen Ebene 9 liegen. Dies ist jedoch nicht zwingend, es wäre vielmehr vorstellbar, daß der zentrale Bereich (vgl. Bezugszeichen 3 in den Figuren 3, 4, 5) gegenüber dem innerhalb des Körpers 5 verlaufenden Abschnitt der Anschlüsse 41, 42 erhöht oder vertieft ist. In jedem Fall ist die Bezugsebene, hinsichtlich der das Kriterium der Punktsymmetrie zu erfüllen ist, die Kontaktebene zwischen dem Chip 1 und dem Chipträger 2.

Die Befestigung der Anschlüsse 42, 41 auf leitenden Flächen 18 der Leiterplatte 17 erfolgt mittels eines Lots 20.

Figur 2 zeigt eine Projektion des Körpers 5 auf die Kontaktebene zwischen Chip 1 und Chipträger 2. Es ist zu erkennen, daß sowohl das Gehäuse 11 als auch die strahlungsdurchlässige Umhüllung 13 hinsichtlich ihrer äußeren Umrisse in Draufsicht punktsymmetrisch sind zum Mittelpunkt 8 des Chips 1. Gleiches gilt für die Projektionen des Körpers 5 und der Umhüllung 13 auf die Kontaktebene zwischen Chip 1 und Chipträger 2. Zusätzlich dazu erfüllen die Elemente Gehäuse 11 und Umhüllung 13 - insbesondere hinsichtlich ihrer Projektionen auf die Kontaktebene zwischen Chip 1 und Chipträger 2 - noch darüber hinausgehende Symmetriebedingungen. Sie sind nämlich symmetrisch zu den beiden Achsen 101, 102, die aufeinander senkrecht stehen. Dadurch wird die Symmetrie von Gehäuse 11 und Umhüllung 13 weiter erhöht, was die Gefahr von Ausfällen des Bauelements weiter reduzieren kann.

Figur 3 zeigt für eine nicht erfindungsgemäße Abwandlung eine Projektion des Chipträgers 2 auf die Kontaktebene zwischen Chip 1 und Chipträger 2. Es ist hier darauf hingewiesen, daß die Anschlüsse 41, 42 noch nicht am Rand des Gehäuses 11 nach unten und auf der Unterseite des Gehäuses 11 nach innen gebogen sind, so wie in Figur 1 dargestellt. Vielmehr sind die Anschlüsse 41, 42 geradlinig aus dem Gehäuse 11 herausgeführt. Figur 3 ist zu entnehmen, daß die Längsmittelachsen 61, 62 der Anschlüsse 41, 42 punktsymmetrisch zum Mittelpunkt 8 des Chips 1 sind. Darüber hinaus ist der gesamte Chipträger 2 punktsymmetrisch zum Mittelpunkt 8 gestaltet. Figur 3 ist auch zu entnehmen, daß der Chipträger einen zentralen Bereich 3 aufweist, auf dem der Chip 1 befestigt ist. Der Chipträger 2 weist darüber hinaus Anschlüsse 41, 42 auf, die der elektrischen Kontaktierung des Chips 1 dienen und die sich vom zentralen Bereich 3 ausgehend nach außen im wesentlichen in einer Ebene erstrecken.

Der Abwandlung in Figur 3 ist desweiteren zu entnehmen, daß auch der Chipträger 2 noch weitere Symmetrien aufweist. Er ist insbesondere symmetrisch zu den beiden senkrecht aufeinanderstehenden Achsen 101, 102, wobei die Achsen 101, 102 dieselben Achsen 101, 102 sind, hinsichtlich derer das Gehäuse 11 und die Umhüllung 13 symmetrisch sind.

In Figur 3 sind ferner noch die entlang der Anschlüsse 41, 42 wirkenden Kräfte durch zwei dicke schwarze Pfeile repräsentiert, die beispielsweise auf die durch das Löten der Anschlüsse 41, 42 entstehende Wärme zurückzuführen sind. Es ist erkennbar, daß die Kräfte in entgegengesetzte Richtungen weisen und betragsmäßig gleich groß sind. Daher kompensieren sich diese Kräfte zumindest im Symmetriepunkt 8.

Figur 3 ist darüber hinaus die Form der Kontaktflächen 14 zwischen der Umhüllung 13 und dem Boden der Vertiefung 12 zu entnehmen. Aufgrund der symmetrischen Gestaltung der Umhüllung 13 und des Gehäuses 11 sowie des Chipträgers 2 sowie aufgrund der Tatsache, daß bei dem hier gezeigten Ausführungsbeispiel auf die "Overmold"-Technik verzichtet worden ist, ergibt sich die Symmetrieeigenschaft für die Kontaktflächen 14 automatisch, da sie sich als komplementär zur Fläche des Chipträgers 2 darstellen, wobei die Fläche des Chipträgers 2 und die Fläche der Kontaktflächen 14 zusammen die Fläche des Bodens der Vertiefung 12 ergeben, welche für sich wieder die geforderte Symmetrie aufweist.

In dem Fall der "Overmold"-Technik, wo aufgrund der teilweisen Bedeckung des Chipträgers 2 mit dem Material des Gehäuses 11 keine automatische Symmetrie mehr für die Kontaktflächen 14 eingestellt ist, müßte durch geeignete Maßnahmen hierfür noch gesorgt werden.

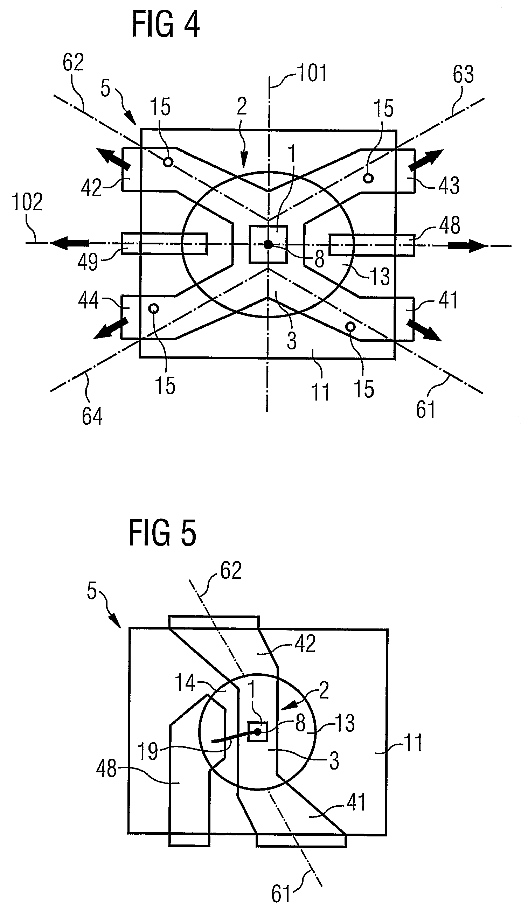

Figur 4 zeigt ein Ausführungsbeispiel für die Gestaltung des Chipträgers 2. Der Chipträger 2 ist in einer Art geformt, wie es an ein Andreaskreuz erinnert. Auch hier sind wieder sämtliche Symmetriebedingungen aus Figur 3 erfüllt. Der Chipträger 2 ist sowohl punktsymmetrisch zum Mittelpunkt 8 als auch achsensymmetrisch zu den Achsen 101, 102. Im Unterschied zu Figur 3 weist der Chipträger 2 anstelle von zwei Anschlüssen 41, 42 vier Anschlüsse 41, 42, 43, 44 auf. Zusätzlich ist noch der Verlauf der Längsmittelachsen 61, 62, 63, 64 dargestellt.

Figur 4 zeigt darüber hinaus auch die Position von Verankerungsmitteln 15, die der Verankerung des Chipträgers 2 in dem Körper 5 dienen. Es ist Figur 4 zu entnehmen, daß die Verankerungsmittel 15 zwar einigermaßen gleichmäßig über den Chipträger 2 verteilt sind, insbesondere ist darauf geachtet worden, daß keiner der durch die beiden senkrecht zueinander stehenden Symmetrieachsen 101, 102 gebildeten Quadranten frei von einem Verankerungsmittel 15 ist. Jedoch ist Figur 4 auch zu entnehmen, daß die Position der Verankerungsmittel 15 nicht die Symmetrie der übrigen hier dargestellten Komponenten aufweisen. Dies ist auch zur Erreichung des erfindungsgemäßen Zweckes nicht notwendig, so daß die Verankerungsmittel 15 ohne Berücksichtigung einer bestimmten Symmetrie nur ausgerichtet auf etwaige noch andere vorliegende Erfordernisse angeordnet werden können.

Es ist darüber hinaus Figur 4 noch zu entnehmen, daß weitere Anschlüsse 48, 49 vorgesehen sind, die den zum Chipträger 2 notwendigen Gegenpol zur Kontaktierung des Chips 1 bilden. Auch die Anschlüsse 48, 49 sind wieder sowohl punktsymmetrisch zum Mittelpunkt 8 als auch achsensymmetrisch zu den Achsen 101, 102 ausgebildet. Die Anordnung der Anschlüsse 41, 42, 43, 44, 48, 49 dergestalt, daß sie neben der Punktsymmetrie noch die doppelte Achsensymmetrie aufweisen, hat den Effekt, daß sich die in Figur 4 wieder als dicke schwarze Pfeile repräsentierten Zugkräfte, die zwischen dem Chipträger 2 und dem Körper 5 respektive zwischen den Anschlüssen 48, 49 und dem Körper 5 wirken, hinsichtlich Translation als auch hinsichtlich eines Drehmomentes gegenseitig kompensieren. Dies bedeutet, daß der Ort des Chips 1 im Belastungsfall sowohl weitgehend frei von translatorischen Kräften als auch weitgehend frei von Drehmomenten ist.

Es wird noch darauf hingewiesen, daß die Anschlüße 41, 42, 43, 44 vom Chipträger aus auch derart nach außen verlaufen können, daß sie den Körper annähernd parallel zur Symmetrieachse 101 verlassen. Die Anschlüsse 41, 42, 43, 44 laufen dann auf Seiten des Körpers 5 nach außen, die frei von den Anschlüßen 48, 49 sind.

Demgegenüber zeigt die nicht erfindungsgemäße Abwandlung der Figur 5 eine Ausgestaltung des Chipträgers 2, wo jedoch keine doppelte Achsensymmetrie des Chipträgers 2 gegeben ist. Vielmehr ist es gemäß Figur 5 vorgesehen, daß der Chipträger 2, also ein zentraler Bereich 3 zusammen mit den Anschlüssen 41, 42 nur eine Punktsymmetrie zum Mittelpunkt 8 aufweist. Dementsprechend können sich hier zwar auch die entlang der Längsmittelachsen 61, 62 wirkenden Zugkräfte kompensieren, jedoch wäre es denkbar, daß beispielsweise bei thermisch erweichtem Körper 5 ein Drehmoment auf den Chip 1 wirkt. Dies ist jedoch bis zu einem gewissen Grade unschädlich, so daß im Rahmen dieser Erfindung durchaus auch Chipträger zugelassen sein sollen, die nicht die doppelte Achsensymmetrie wie in den Figuren 3 und 4 aufweisen.

Figur 5 ist zudem noch zu entnehmen, daß ein weiterer Anschluß 48 zur Kontaktierung der Oberseite des Chips 1 vorgesehen sein kann, der nicht die aufgeführten Symmetriebedingungen erfüllt.

Es wird noch auf den Bonddraht 19 hingewiesen, der den Anschluß 48 mit der dem Chipträger 2 gegenüberliegenden Seite des Chips 1 verbindet.

Der Schutzumfang der Erfindung ist nicht durch die Beschreibung der Erfindung anhand der Ausführungsbeispiele beschränkt.

## Patentansprüche

1. Optoelektronisches Bauelement, enthaltend
- einen optoelektronischen Chip (1),
- einen einstückig ausgebildeten Chipträger (2) mit einem zentralen Bereich (3), auf dem der Chip (1) befestigt ist, und mit genau vier elektrischen Anschlüssen (41, 42, 43, 44), die vom zentralen Bereich (3) des Chipträgers (2) ausgehend nach außen verlaufen, und
- von dem Chipträger (2) getrennte, genau zwei weitere elektrische Anschlüsse (48, 49),
wobei
- der Chip (1) und Teile des Chipträgers (2) von einem Körper (5) umhüllt sind,
- der Körper (5) ein Gehäuse (11) umfasst, das eine Vertiefung (12) mit einem Boden aufweist,
- in der Vertiefung (12) eine strahlungsdurchlässige Umhüllung (13) angeordnet ist, in die der Chip (1) eingebettet ist,
- die Projektion der Umhüllung (13) auf die Kontaktebene (9) zwischen dem Chip (1) und dem Chipträger (2) punktsymmetrisch zur Projektion des Mittelpunkts (8) des Chips (1) ist,
- die Projektion des Körpers (5) sowie von Längsmittelachsen (61, 62, 63, 64) der elektrischen Anschlüsse (41, 42, 43, 44) des Chipträgers (2) auf die Kontaktebene (9) jeweils punktsymmetrisch zur Projektion des Mittelpunkts (8) des Chips (1) sind,
- die Projektion der Anschlüsse (41, 42, 43, 44) des Chipträgers (2) als auch der weiteren Anschlüsse (48, 49) auf die Kontaktebene (9) sowohl punktsymmetrisch ist zur Projektion des Mittelpunkts (8) des Chips (1) als auch achsensymmetrisch zu zwei Symmetrieachsen (101, 102) ausgebildet sind, sodass die Anschlüsse (41, 42, 43, 44) des Chipträgers (2) und die weiteren Anschlüsse (48, 49) neben einer Punktsymmetrie noch eine doppelte Achsensymmetrie aufweisen,
- die Symmetrieachsen (101, 102) in Projektion auf die Kontaktebene (9) senkrecht aufeinander stehen und durch den Mittelpunkt (8) des Chips (1) verlaufen,
- der Chipträger (2) in Projektion auf die Kontaktebene (9) andreaskreuzförmig ist, und
- die weiteren Anschlüsse (48, 49) auf einer der Symmetrieachsen (102) liegen.

2. Optoelektronisches Bauelement nach Anspruch 1,
bei dem die elektrischen Anschlüsse (41, 42, 43, 44) des Chipträgers (2) vom Chipträger (2) ausgehend in einer Ebene nach außen verlaufen.

3. Optoelektronisches Bauelement nach Anspruch 1 oder 2,
bei dem die Kontaktebene (9) zwischen dem Chip (1) und dem Chipträger (2) durch eine Montageebene des Chips (1) auf den Chipträger (2) gegeben ist.

4. Optoelektronisches Bauelement nach einem der Ansprüche 1 bis 3,
bei dem der Körper (5) aus einem strahlungsdurchlässigen Material besteht.

5. Optoelektronisches Bauelement nach einem der vorhergehenden Ansprüche,
bei dem die Projektion von Kontaktflächen (14) zwischen der Umhüllung (13) und dem Boden der Vertiefung (12) auf die Kontaktebene (9) zwischen dem Chip (1) und dem Chipträger (2) punktsymmetrisch ist zur Projektion des Mittelpunkts (8) des Chips (1).

6. Optoelektronisches Bauelement nach einem der Ansprüche 1 bis 5,
bei dem Mittel zur Verankerung (15) des Chipträgers (2) in dem Körper (5) vorgesehen sind, die unsymmetrisch angeordnet sind.

7. Optoelektronisches Bauelement nach Anspruch 6, bei dem die Mittel zur Verankerung (15) des Chipträgers (2) in dem Körper (5) gleichmäßig über den Chipträger (2) verteilt sind.

8. Optoelektronisches Bauelement nach einem der Ansprüche 1 bis 5,
bei dem Mittel zur Verankerung (15) des Chipträgers (2) in dem Körper (5) vorgesehen sind, deren Projektion auf die Kontaktebene zwischen dem Chip (1) und dem Chipträger (2) punktsymmetrisch ist zur Projektion des Mittelpunkts (8) des Chips (1).

9. Optoelektronisches Bauelement nach einem der Ansprüche 1 bis 8,
bei dem jeder elektrische Anschluss (41, 42, 43, 44) des Chipträgers (2) und jeder weitere Anschluss (48, 49) auf einer Rückseite des Körpers (5) eine Lötfläche aufweist.

10. Anordnung mit einem optoelektronischen Bauelement nach Anspruch 9,
bei dem die Lötflächen (16) des Chipträgers (2) mit leitenden Flächen (18) einer Leiterplatte (17) verlötet sind.

## Claims

1. Optoelectronic component, comprising
- an optoelectronic chip (1),
- an integrally embodied chip carrier (2) having a central region (3), on which the chip (1) is fixed, and having exactly four electrical connections (41, 42, 43, 44) running outwards proceeding from the central region (3) of the chip carrier (2),
- exactly two further electrical connections (48, 49) separated from the chip carrier (2),
wherein
- the chip (1) and parts of the chip carrier (2) are encapsulated by a body (5),
- the body (5) comprises a housing (11), which has a depression (12) having a base,
- a radiation-transmissive encapsulation (13) is arranged in the depression (12), the chip (1) being embedded into said encapsulation,
- the projection of the encapsulation (13) onto the contact plane (9) between the chip (1) and the chip carrier (2) is point-symmetrical with respect to the projection of the midpoint (8) of the chip (1),
- the projection of the body (5) and of longitudinal sinter axes (61, 62, 63, 64) of the electrical connections (41, 42, 43, 44) of the chip carrier (2) to the contact plane (9) is in each case point-symmetrical with respect to the projection of the midpoint (8) of the chip (1),
- the projection of the connections (41, 42, 43, 44) of the chip carrier (2) and of the further connections (48, 49) onto the contact plane (9) is point-symmetrical with respect to the projection of the midpoint (8) of the chip (1) and is also embodied axially symmetrically with respect to two axes (101, 102) of symmetry, such that the connections (41, 42, 43, 44) of the chip carrier (2) and the further connections (48, 49) also have a double axial symmetry alongside a point symmetry,
- the axes (101, 102) of symmetry in projection onto the contact plane (9) are perpendicular to one another and run through the midpoint (8) of the chip (1),
- the chip carrier (2) in projection onto the contact plane (9) is in the shape of a St. Andrew's cross, and
- the further connections (48, 49) lie on one of the axes (102) of symmetry.

2. Optoelectronic component according to Claim 1, wherein the electrical connections (41, 42, 43, 44) of the chip carrier (2) run outwards in one plane proceeding from the chip carrier (2).

3. Optoelectronic component according to Claim 1 or 2,
wherein the contact plane (9) between the chip (1) and the chip carrier (2) is given by a mounting plane of the chip (1) onto the chip carrier (2).

4. Optoelectronic component according to any of Claims 1 to 3,
wherein the body (5) consists of a radiation-transmissive material.

5. Optoelectronic component according to any of the preceding claims,
wherein the projection of contact layers (14) between the encapsulation (13) and the base of the depression (12) onto the contact plane (9) between the chip (1) and the chip carrier (2) is point-symmetrical with respect to the projection of the midpoint (8) of the chip (1).

6. Optoelectronic component according to any of Claims 1 to 5,
wherein means for anchoring (15) the chip carrier (2) in the body (5) are provided, which are arranged asymmetrically.

7. Optoelectronic component according to Claim 6,
wherein the means for anchoring (15) the chip carrier (2) in the body (5) are distributed uniformly over the chip carrier (2).

8. Optoelectronic component according to any of Claims 1 to 5,
wherein means for anchoring (15) the chip carrier (2) in the body (5) are provided, the projection of which onto the contact plane between the chip (1) and the chip carrier (2) is point-symmetrical with respect to the projection of the midpoint (8) of the chip (1).

9. Optoelectronic component according to any of Claims 1 to 8,
wherein each electrical connection (41, 42, 43, 44) of the chip carrier (2) and each further connection (48, 49) has a soldering area on a rear side of the body (5).

10. Arrangement comprising an optoelectronic component according to Claim 9,
wherein the soldering areas (16) of the chip carrier (2) are soldered with conductive areas (18) of a printed circuit board (17).

## Revendications

1. Composant optoélectronique, contenant :
- une puce optoélectronique (1),
- un support de puce (2) réalisé en un seul tenant comportant une zone centrale (3), sur laquelle la puce (1) est fixée et comportant exactement quatre connexions électriques (41, 42, 43, 44), qui s'étendent à partir de la zone centrale (3) du support de puce (2) vers l'extérieur, et
- exactement deux autres connexions électriques (48, 49), séparées du support de puce (2),
dans lequel
- la puce (1) et des parties du support de puce (2) sont enveloppées par un corps (5),
- le corps (5) comprend un boîtier (11), qui présente une cavité (12) avec une base,
- dans la cavité (12) est disposée une enveloppe (13) perméable au rayonnement, dans laquelle la puce (1) est incorporée,
- la projection de l'enveloppe (13) sur le plan de contact (9) entre la puce (1) et le support de puce (2) est à symétrie ponctuelle par rapport à la projection du point central (8) de la puce (1),
- la projection du corps (5) ainsi que des axes médians longitudinaux (61, 62, 63, 64) des connexions électriques (41, 42, 43, 44) du support de puce (2) sur le plan de contact (9) sont respectivement à symétrie ponctuelle par rapport à la projection du point central (8) de la puce (1),
- la projection des connexions (41, 42, 43, 44) du support de puce (2) ainsi que des autres connexions (48, 49) sur le plan de contact (9) est conçue tant à symétrie ponctuelle par rapport à la projection du point central (8) de la puce (1) qu'à symétrie axiale par rapport à deux axes de symétrie (101, 102), de sorte que les connexions (41, 42, 43, 44) du support de puce (2) et les autres connexions (48, 49) présentent en dehors d'une symétrie ponctuelle également une double symétrie axiale,
- les axes de symétrie (101, 102) sont disposés perpendiculairement l'un sur l'autre dans la projection sur le plan de contact (9) et s'étendent à travers le point central (8) de la puce (1),
- le support de puce (2) a une forme de croix de saint André dans la projection sur le plan de contact (9), et
- les autres connexions (48, 49) sont situées sur un des axes de symétrie (102).

2. Composant optoélectronique selon la revendication 1,
dans lequel les connexions électriques (41, 42, 43, 44) du support de puce (2) s'étendent à partir du support de puce (2) vers l'extérieur dans un plan.

3. Composant optoélectronique selon la revendication 1 ou 2,
dans lequel le plan de contact (9) entre la puce (1) et le support de puce (2) est constitué par un plan de montage de la puce (1) sur le support de puce (2).

4. Composant optoélectronique selon une des revendications 1 à 3,
dans lequel le corps (5) est constitué d'un matériau perméable au rayonnement.

5. Composant optoélectronique selon une des revendications précédentes,
dans lequel la projection des surfaces de contact (14) entre l'enveloppe (13) et la base de la cavité (12) sur le plan de contact (9) entre la puce (1) et le support de puce (2) est à symétrie ponctuelle par rapport à la projection du point central (8) de la puce (1).

6. Composant optoélectronique selon une des revendications 1 à 5,
dans lequel des moyens d'ancrage (15) du support de puce (2) dans le corps (5) sont prévus, qui sont disposés asymétriquement.

7. Composant optoélectronique selon la revendication 6,
dans lequel les moyens d'ancrage (15) du support de puce (2) dans le corps (5) sont répartis uniformément sur le support de puce (2).

8. Composant optoélectronique selon une des revendications 1 à 5,
dans lequel des moyens d'ancrage (15) du support de puce (2) dans le corps (5) sont prévus, dont la projection sur le plan de contact entre la puce (1) et le support de puce (2) est à symétrie ponctuelle par rapport à la projection du point central (8) de la puce (1).

9. Composant optoélectronique selon une des revendications 1 à 8,
dans lequel chaque connexion électrique (41, 42, 43, 44) du support de puce (2) et chaque autre connexion (48, 49) sur un côté arrière du corps (5) présente une surface de brasage.

10. Dispositif comportant un composant optoélectronique selon la revendication 9,
dans lequel les surfaces de brasage (16) du support de puce (2) sont brasées avec les surfaces conductrices (18) d'une plaquette de circuit imprimé (17).
